(19) Europäisches Patentamt
European Patent Office
Office européen des brevets

(11) **EP 3 734 477 B1**

(12) **EUROPEAN PATENT SPECIFICATION**

(45) Date of publication and mention of the grant of the patent:
**29.03.2023 Bulletin 2023/13**

(21) Application number: **19172473.1**

(22) Date of filing: **03.05.2019**

(51) International Patent Classification (IPC):
**G06F 30/17** (2020.01)   **G06F 30/23** (2020.01)

(52) Cooperative Patent Classification (CPC):
**G06F 30/17; G06F 30/23**

(54) **METHOD FOR STRUCTURAL OPTIMIZATION OF OBJECTS USING A DESCRIPTOR FOR DEFORMATION MODES**

VERFAHREN ZUR STRUKTUROPTIMIERUNG VON OBJEKTEN UNTER VERWENDUNG EINES DESKRIPTORS FÜR DEFORMATIONSMODI

PROCÉDÉ D'OPTIMISATION STRUCTURALE D'OBJETS À L'AIDE D'UN DESCRIPTEUR DE MODES DE DÉFORMATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**04.11.2020 Bulletin 2020/45**

(73) Proprietor: **Honda Research Institute Europe GmbH**
**63073 Offenbach/Main (DE)**

(72) Inventors:
• **WOLLSTADT, Patricia**
**63073 Offenbach (DE)**
• **AULIG, Nikola**
**63073 Offenbach (DE)**
• **Skylar Sible**
**dublin Ohio 43016 (US)**

(74) Representative: **Beder, Jens**
**Mitscherlich PartmbB**
**Patent- und Rechtsanwälte**
**Sonnenstraße 33**
**80331 München (DE)**

(56) References cited:
**EP-A1- 2 953 040    CN-A- 106 227 922**

• **WANG SHENGFA ET AL: "Topology and Shape Preserved Lightweight of Shell Models Utilizing Heat Diffusion", 2017 INTERNATIONAL CONFERENCE ON VIRTUAL REALITY AND VISUALIZATION (ICVRV), IEEE, 21 October 2017 (2017-10-21), pages 91-96, XP033554143, DOI: 10.1109/ICVRV.2017.00026 [retrieved on 2019-05-21]**
• **ERCAN M DEDE ET AL: "Topology optimization of structures with integral compliant mechanisms for mid-frequency response", STRUCTURAL AND MULTIDISCIPLINARY OPTIMIZATION, SPRINGER, BERLIN, DE, vol. 39, no. 1, 23 September 2008 (2008-09-23), pages 29-45, XP019700051, ISSN: 1615-1488**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The invention concerns a method for structural optimization, in particular structural optimization of object design with regard to crashworthiness using a sparse geometric descriptor for deformation modes.

Objects are physical objects, for example, automotive objects such as vehicles or vehicle components. Physical objects may also be planes or infrastructure objects such as bridges or buildings or components thereof. A physical object has a definite structure that describes a design defined by a spatial arrangement of elements and material of the physical object and in particular includes a geometric shape of the physical object.

The design includes the geometric shape of the physical object, which is the form of the physical object or its external surface (external boundary), as opposed to other properties such as color, texture or material composition. These other properties, especially also including thickness of a material, may also be defined by the design.

Evaluating the design of the physical object using computer-implemented simulation methods has important application areas in many technical fields. Structural optimization refers to a kind of optimization that aims at improving the structure of the physical object with respect to specific design targets. In structural optimization, design variables correspond to parameters that describe the structure of the physical object.

In the field of automotive design, structural optimization of physical objects is an important part of crashworthiness optimization. Crashworthiness may be defined as the ability of the structure to protect persons occupying the structure during an impact in a crash scenario.

Crashworthiness is not only tested when investigating the safety of road vehicles, but also when determining behavior of an airframe of an aircraft in a crash scenario. Crashworthiness can be assessed retrospectively by analyzing crash outcomes, but is increasingly examined prospectively using computer implemented models.

Another important area of applying structural analysis and structural optimization, in particular as part of a kind of "crashworthiness" optimization, applies to infrastructure objects such as bridges or buildings. The structural analysis and optimization of building structures is of particular importance in areas where seismic activity is a common phenomenon.

Structural optimization with respect to a deformation of the vehicle body as a design criterion enables the design engineer to fulfil, for example, the requirements describing the crashworthiness of the vehicle. Designing entire vehicle bodies or components of vehicles in order to exhibit a specific crash behavior involves simulating and evaluating geometrical deformations with respect to different design parameters.

The publication "Structural Optimization Methods and Techniques to design Efficient Car Bodies" by Leiva, J. P., (2008), 12th European Conference on Research and Advanced Technology for Digital Libraries, ECDL 2008, 5173 LNCS discusses structural optimization methods for designing car bodies and classifies different types of structural optimization methods.

In current applications, a deformation behavior of an automotive component in a crash simulation or crashworthiness optimization is typically measured by displacement of single node or multiple nodes in a finite element model (FE model). Different design variables are tested iteratively during the optimization. This limits the use of geometric constraints in computationally implemented optimization to deformations that are sufficiently described by the displacement of the individual nodes of interest. The nodes of interest have to be known in advance.

This allows only limited control of deformation behavior of the automotive components during simulation and optimization. The analysis is also restricted to basic deformation modes only.

The current design process therefore requires many iterations for optimization and even visual inspection of a component's deformation behavior by an experienced design engineer.

The simulation of geometric deformations of complex structures and an evaluation of large amounts of data obtained by the simulation is computationally costly and currently a time consuming process. Designing a physical object taking into account a novel deformation mode or even a deformation of a higher complexity including, for example, a displacement involving a large set of nodes in a representation of the complex structure, is at least costly in terms of computing resources and time, or even entirely infeasible.

The known structural optimization approaches may therefore benefit from improvements with respect to a reduction in the required processing resources and processing time necessary for the structural optimization of a physical object.

The invention is defined in the independent claims. Advantageous features are defined in the dependent claims.

The computer-implemented method for structural optimization of a set of design variables of a design of a physical object with respect to a deformation caused by external or internal forces according to a first aspect of the invention comprises a step of generating a spectral design representation of an initial design of the physical object. The physical object is a vehicle, for example an automotive vehicle or an airplane, or a component thereof, and the optimization is performed with respect to design variables. The design variables comprise at least one of a thickness of a structural member, a choice of a material, and a wing span of a wing.

The spectral design representation may be achieved by first obtaining a mesh representation of the design of the physical object and then transforming the representation to a spectral design representation, which is a representation in the spectral domain.

Publications "Spectral Compression of Mesh Geometry" by Z. Karni and C. Gotsman, 2000. Proceedings of the 27th Annual Conference on Computer Graphics and Interactive Techniques - SIGGRAPH '00, 279-286, and "Laplacian Mesh Processing" by O. Sorkine, 2005, EUROGRAPHICS '05, Vol. 109, 318, provide further information on spectral representation of surface meshes.

A deformation mode is determined, which defines a desired deformed state of the physical object. Such deformed state is, for example, caused by an external force exerted on the initially un-deformed physical object. The at least one deformed geometric shape originates from the un-deformed geometric shape and is deformed in the determined deformation mode. The deformation mode describes a target deformation. A plurality of basic deformation modes may be defined, wherein these basic deformation modes may be combined to establish a desired final deformation.

The method generates a spectral basis comprising a plurality of spectral coefficients each associated with an eigenvector of the spectral basis by performing a spectral decomposition of a mesh representation of the design of the physical object and the desired deformed state of the physical object, respectively. Spectral coefficients of the spectral representation of the deformed state on the basis of the coefficients' relevance are selected. A spectral descriptor of the deformation mode is generated on the basis of the spectral design representation and a spectral representation of the desired deformed state of the physical object according to the at least one deformation mode. The step of generating the spectral descriptor includes determining a difference between the selected spectral coefficients of the spectral design representation and corresponding spectral coefficients of at least one spectral representation of the desired deformed state. The method further comprises a step of performing a structural optimization of the design variables, which define the design of the un-deformed, original design of the physical object, using the generated spectral descriptor as a parameter in an objective function of the structural optimization or in at least one constraint of the structural optimization to generate an optimized set of design variables of the physical object. The method outputs the optimized set of design variables of the object and on the basis of this output the physical object is finally manufactured. The method provides data on a desired plastic deformation behavior of the physical object, crucial to component design in automotive engineering and represents a powerful design tool. The spectral descriptor provides a novel parameterization of deformation using a geometric descriptor that enables the representation of complex plastic deformations in a sparse and simultaneously quantitative manner. This spectral descriptor is used directly as an optimization constraint or optimization objective in the optimization process and therefore guides the structural optimization directly towards a desired deformation behavior of the physical object. Using spectral decomposition enables to generate a sparse descriptor using relatively few coefficients for describing a specific deformation mode. The sparse descriptor provides a much more concise description of the deformed geometry than a complete geometric model, e.g., a surface mesh model of the geometric structure of the physical object. Simultaneously, a high amount of geometric information on the structure of the physical object is not only preserved but also integrated into the structural optimization of the geometric structure. Thus, the method enables to use complex geometric information directly in the optimization process.

Constructing the spectral descriptor from a spectral decomposition, in particular a 3D-spectral decomposition of the geometry provides an invertible description of the design of the physical object. The mesh representation can accordingly be reconstructed from its spectral representation. The description is a quantitative description, which simultaneously may be stored and reconstructed with an acceptable loss of information.

A preferred embodiment includes generating a set of spectral coefficients for the descriptor by selecting spectral coefficients based on a value or relative magnitude of the spectral coefficients.

Generating the spectral descriptor by selecting spectral coefficients enables to focus the optimization on those spectral components that provide the predominant contributions to the predetermined deformation mode. This results in a computationally efficient optimization process. Using the value or relative magnitude of the respective spectral coefficients as selection criterion provides an efficient way to identify those spectral components that influence the deformation mode of interest for the physical object at most.

Advantageously, selecting the set of spectral coefficients includes selecting a predetermined number of spectral coefficients of the spectral representation of the deformed state with the largest difference.

Alternatively, selecting the set of spectral coefficients includes comparing the determined difference to a threshold and selecting those spectral coefficients, which exceed the threshold to generate the spectral descriptor. The threshold may be adjustable.

Those spectral components that contribute to the targeted deformation defined by the deformation mode are taken into consideration and those spectral components that remain constant (or at least contribute less) between deformed and un-deformed geometric shapes are neglected. The spectral descriptor is therefore a comprehensive, but sparse and therefore computationally efficient description of the geometric shape of the physical object with respect to the determined deformation mode.

The step of determining the difference may include determining the difference between the spectral coefficients of the shape representation of the un-deformed shape and corresponding average spectral coefficients of plural shape representations of similarly deformed geometric shapes.

The threshold may be determined from an average value of the spectral coefficients of the un-deformed geometric shape.

The method therefore obtains a sparse description of the geometric information relevant to deform the un-deformed geometric shape and the deformed geometric shape, as those spectral components that contribute to the targeted deformation defined by the deformation mode are taken into consideration and those spectral components that remain constant between deformed and un-deformed geometric shape can be ignored.

The method may comprise determining a quality of the determined spectral descriptor by reconstructing a mesh representation (reconstructed mesh representation) of the geometric shape of the deformed geometric shape from the selected descriptor and thus the set of spectral coefficients.

Determining the quality of the spectral descriptor and adapting the process of generating the spectral descriptor based on the determined quality by adapting the threshold ensures a quality of the optimization result without requiring the design engineer to intervene manually during the process of generating the spectral descriptor. The quality may be estimated using a measure describing the deviation of the reconstructed mesh from the original mesh. The differences can be summed up and the quality is considered to be sufficient when the sum does not exceed a certain threshold. The threshold can be set by the design engineer.

An embodiment of the method optimizes a geometric shape of a vehicle, in particular a ground vehicle, an air vehicle or a space vehicle, an infrastructure object or a building as the physical object. The physical object may also be a part or component of the vehicle, ground vehicle, air vehicle or space vehicle, the infrastructure object or the building.

Physical objects whose design involves many complex aspects and which have to fulfill many different requirements influenced by their geometric structure profit most from the computer-implemented structural optimization according to the inventive method.

The set of design variables may include parameters that change directly or indirectly at least one dimension of the object, grid locations of a mesh representation of the object and/or material properties of the object, including thickness.

The method provides an efficient optimization of design variables taking into account the geometric structure of the object.

The method according to an embodiment determines the deformation mode as at least one of a bending deformation mode, an axial deformation mode or a crumbling deformation mode.

A computer program with program-code for executing the steps according to a second aspect solves the technical problem, when the program is loaded and executed on a computer or digital signal processor.

A computer program-product with program-code stored on a machine-readable medium for executing the steps according to a third aspect solves the technical problem, when the program is loaded and executed on a computer or digital signal processor.

The method is particularly suited for a highly automated implementation as a software running on one singular or a plurality of processors executing the method steps and arranged with corresponding memory resources. The design engineer obtains a powerful optimization tool for designing physical objects by the computer-implemented method and benefits from improved design process.

Embodiments of the invention are discussed with reference to the figures, in which

Fig. 1  provides a block diagram of a method for structural optimization using a spectral descriptor for a deformation mode,

Fig. 2  shows a block diagram of steps for generating the descriptor for the deformation mode in an embodiment,

Fig. 3  depicts examples for specific deformation modes of a physical object,

Fig. 4  provides a comparison of an original design and a geometric shape reconstructed from characteristic spectral components for three deformation modes, and

Fig. 5  shows a block diagram of steps for structural optimization using the sparse spectral descriptor for a deformation mode in an embodiment.

In the figures, same reference signs denote same or corresponding elements. The discussion of embodiments with reference to the figures omits a repetitive discussion of elements with same reference signs in different figures where considered possible without adversely affecting the understanding of the invention.

The invention improves the design process for physical objects by parameterizing a desired plastic deformation using a sparse geometric descriptor for use in a structural optimization. In the following description of the method, a structural optimization of a physical object in the field of automotive design is used merely as an example. The physical object may be a vehicle component of a road vehicle. The automotive engineer designs vehicle components to deform in a specific way to protect the occupants in the cabin of the vehicle in case of a crash. The vehicle component is one particular example for a physical object.

Deformation refers to any change in a size or shape of an object, in materials science, due to an applied force, in which case the deformation energy is transferred by work or even a change in temperature, in which case the deformation energy is dissipated. In the first case, the work is a result of tensile, compressive forces or shear, bending or torsion. Deformation is sometimes described as strain.

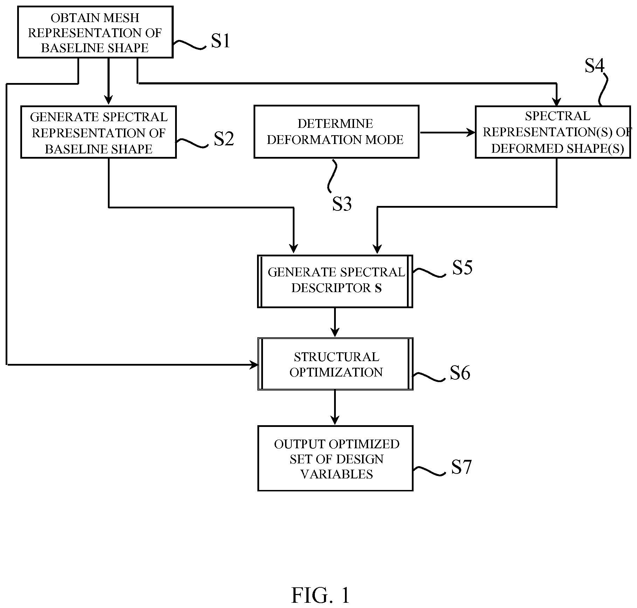

Fig. 1 provides a block diagram of a method for structural optimization with a spectral descriptor for a deformation mode.

The invention uses a spectral representation of a design of the physical object, in particular its shape, to define a specific descriptor. The geometry of the geometric shape of the physical object, for example, a 3-dimensional (3D) object, is obtained in a first step S1 as a mesh representation including a number of N nodes. The un-deformed 3D-object defines an un-deformed geometric shape (initial or baseline geometric shape).

A mesh or surface mesh is a polygon mesh. The polygon mesh comprises a set of vertices, edges and faces that define the shape of a polyhedral object, for example in 3D computer graphics and solid modeling. The faces may consist of triangles each comprising three nodes and the edges connecting the nodes. The set of triangles approximates the surface of the physical object in space.

The invention relies on the so-called spectral representation of a geometry to define a descriptor. Similar to Fourier analysis in the field of signal processing, a spectral decomposition is applied to the obtained mesh representation of the baseline geometric shape. Spectral decomposition methods compute the eigenvectors of a suitable, discrete operator on the mesh, e.g., the Laplace-Beltrami-Operator. The eigenvectors, $\{\psi_1, ... \psi_i, ... , \psi_N\}$, form an orthonormal basis, in which functions defined on the geometry can be represented. The mapping of the functions defined on the geometry into the spectral basis form a spectral representation of the geometry.

Generating a spectral design representation of the baseline shape in step S2 may be performed using the geometries' Euclidian coordinates as functions. Assuming a basis of N eigenvectors $\psi_i$, with N representing the number of nodes in the obtained mesh representation, all functions f on the mesh can be represented as

$$f = \sum_{i=1}^{N} \alpha_i \psi_i \; ; \qquad\qquad (1)$$

In expression (1), the term $\psi_i$ denotes the $i^{th}$ eigenvector (spectral component), the term $\alpha_i$ denotes the corresponding spectral coefficient, obtained from projecting the function along the direction of the $i^{th}$ eigenvector, $\alpha_i = \psi_i^T \cdot f$, and N is the number of nodes of the mesh representation. To obtain a spectral representation of the mesh, the Euclidean coordinates representing the mesh in the spatial domain are considered as mesh functions $f^x$, $f^y$, and $f^z$ and mapped into the spectral domain

$$f^x = \sum_{i=1}^{N} \alpha_i^x \psi_i \; ; \qquad\qquad (2)$$

$$f^y = \sum_{i=1}^{N} \alpha_i^y \psi_i \; ; \qquad\qquad (3)$$

$$f^z = \sum_{i=1}^{N} \alpha_i^z \psi_i \; ; \qquad\qquad (4)$$

with spectral coefficients $\alpha_i^x, \alpha_i^y$, and $\alpha_i^z$, where again coefficients are obtained by projecting functions along the direction of the respective eigenvectors, $\alpha_i^x = \psi_i^T \cdot f^x, \alpha_i^y = \psi_i^T \cdot f^y, \alpha_i^z = \psi_i^T \cdot f^z$. The spectral representation of the geometry of the geometric shape is an alternative representation of the design with interesting properties: each eigenvector represents a spectral component. An eigenvector associated with smaller eigenvalues describes low-frequency functions on the mesh representation, larger eigenvalues describe more high-frequent functions on the mesh. Furthermore, the spectral decomposition of the mesh representation is invertible, such that a mesh representation can be generated ("reconstructed") from its spectral representation. In most cases, a subset of eigenvectors of a size M, where M < N, is sufficient to reconstruct the original mesh representation of an object with an acceptable loss. Currently, this property is used to provide a compression algorithm for shape geometries. Publication "Spectral Compression of Mesh Geometry" by Z. Karni and C. Gotsman, 2000, Proceedings of the 27th Annual Conference on Computer Graphics and Interactive Techniques - SIGGRAPH '00 279-286 describes such compression algorithms.

In addition to obtaining a mesh representation of the un-deformed geometric shape of the physical object in step S1, and generating a spectral design representation of the baseline geometric shape therefrom in step S2, in a step S3 a deformation mode is determined. The determined deformation mode defines a specific geometric deformation of the mesh representation of the un-deformed geometric shape into the deformed state of the physical object.

The steps S1, S2 and S3 are not necessarily performed in the order indicated by their numerals. These steps may be performed sequentially or, at least in part, in parallel.

The method generates in step S4 a spectral representation of the deformed geometric shape according to the determined deformation mode.

Generally, geometries with isometric surfaces share a same spectral basis. Geometries are isometric if there exists a transformation from one geometric shape to another geometric shape that preserves all distances on the surface of the shape (geodesic distance). For a set of isometric geometries, the spectral basis thus provides a common space, in which all geometries can be represented simultaneously. Deformations resulting from crash simulations may thus be visualized in their common spectral representation assuming that deformations from crash simulations are isometries of the initial, un-deformed geometric shape entering the simulation. The authors describe this aspect in "Machine Learning Approaches for Data from Car Crashes and Numerical Car Crash Simulation" by J. Garcke and R. Iza-Teran, 2017, International Association for the Engineering Analysis Community- NAFEMS, and in the PhD thesis titled "Geometrical Methods for the Analysis of Simulation Bundles" by R. Iza-Teran, Bonn, September 2016 and published in 2017.

Individual spectral components $\psi_i$ provide specific contributions to the overall deformation, for example, translation or rotation of the physical object during the crash. A corresponding proposal is included in "Geometrical Method for Low-Dimensional Representation of Simulations" by R. Iza-Teran and J. Garcke, 2019, arXiv preprint: 1903.077744. A specific spectral component $\psi_i$ relevant to a specific deformation can be identified by a high corresponding spectral coefficient $\alpha_i$.

In subsequent step S5, a spectral descriptor is generated from the spectral design representation of the baseline shape and at least one spectral representation of a deformed shape. The spectral descriptor can be determined by selecting a set S of relevant spectral coefficients $\alpha_j$ of the spectral representation of the deformed shape with

$$\alpha_j \in \{\alpha_i^x, \alpha_i^y, \alpha_i^z\} \qquad (5)$$

and

$$|S| = M \ll N; \qquad (6)$$

In expression (6), S denotes the set of relevant spectral coefficients $\alpha_j$, |S| denotes a number M of relevant spectral coefficients $\alpha_j$ in the set S, and N the number of nodes of the mesh representation. Each relevant coefficient

$$\alpha_j \in S; \qquad (7)$$

describes the relevance of the spectral component (eigenvector) $\psi_i$ corresponding to the relevant coefficient $\alpha_j$. The relevance can be determined by a magnitude of the coefficients $\alpha_j$ relative to a suitable baseline. The suitable baseline may be determined by the spectral coefficients of the un-deformed geometric shape.

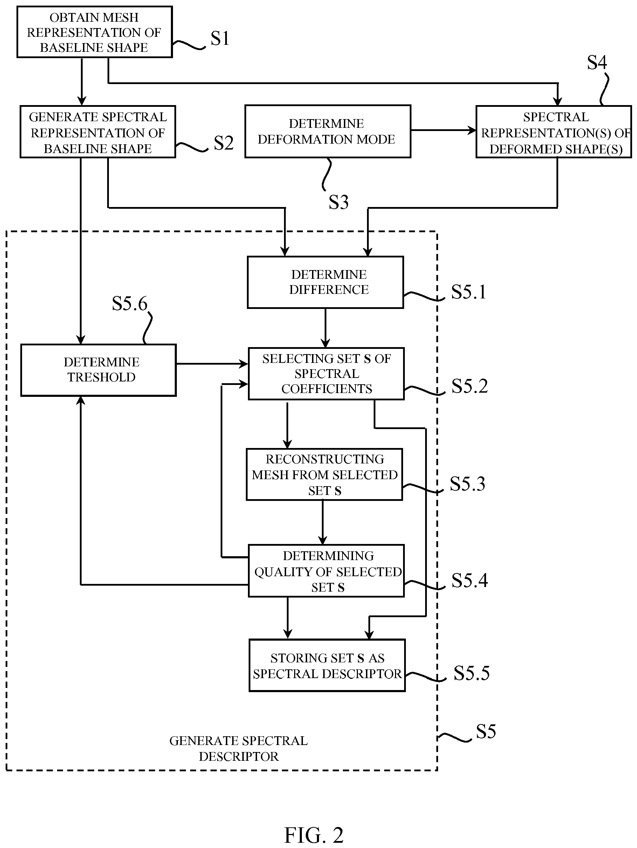

Alternatively, the suitable baseline can be determined by an average magnitude of spectral coefficients $\{\alpha_i^x, \alpha_i^y, \alpha_i^z\}$ of the un-deformed geometric shape. Generating the spectral descriptor is discussed with more detail with reference to fig. 2.

The generated spectral descriptor S enables an efficient representation of the shape geometry and in particular the plastic deformation of the geometric shape with respect to an un-deformed geometric shape. It also allows to describe even complex deformation modes, e.g., axial bending, in a quantitative and simultaneously sparse manner. The spectral descriptor enables to directly use of deformation modes as an objective or constraint in a structural optimization of the physical object.

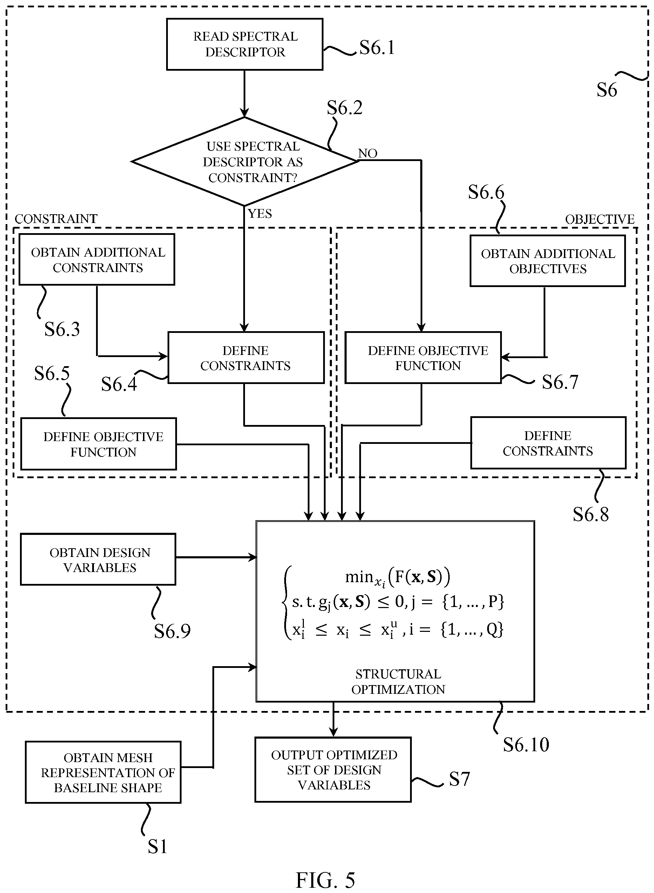

In step S7, the spectral descriptor S is used in a structural optimization in order to generate and optimize a set of design variables of the original design. The design variables are parameters that can change directly or indirectly a dimension of elements, grid locations and or material properties of the physical object. The structural optimization using a deformation mode as an objective or constraint in the structural optimization of the physical object based on the generated spectral descriptor is discussed in more detail with reference to fig. 5 below.

The design variables may be numerical values that can be varied by the design engineer to define a physical object. Placing these design variables along orthogonal axes defines a design space, or a set of possible design options. A design variable is a specification that is controllable from the point of view of the design engineer. For instance, the thickness of a structural member can be considered a design variable. Another design variable might be the choice of a material. Design variables can be continuous, such as a wing span of a wing of an aircraft, or discrete, e.g., the number of ribs in the wing, or Boolean, for example, describing whether to build a monoplane or a biplane. Design variables may have boundaries, that is, they often have maximum and minimum values. Depending on the method for solving the optimization problem, these boundaries can be treated as constraints or side constraints during the optimization.

The optimized set of design variables resulting from the optimization, is then output in subsequent step S7 and is the basis for producing the physical object.

Fig. 2 provides a block diagram with steps for generating the geometric descriptor S for a deformation mode in an embodiment in more detail.

Step S1, obtaining a mesh representation, step S2, generating a spectral design representation of the baseline shape, step S3, determining a deformation mode and of generating a spectral representation of the deformed geometric shape in fig. 2 correspond to the steps discussed with reference to fig. 1.

Step S1 obtains a baseline geometric shape in form of a mesh representation. The deformation mode is determined in step S3. A mesh representation of a deformed geometric shape according to the determined deformation mode on the basis of the un-deformed mesh representation of the baseline geometric shape is obtained in step S4.

It is noted that in some embodiments plural deformed mesh representations are generated characterizing different deformation modes, wherein the plural mesh representations derive from the same un-deformed geometric shape. Similar deformation modes may be, for example, deformation modes that have a same deformation type, for example an axial or a bending type deformation, but mechanical forces are varying in a predefined range resulting in different, but generally similar, deformed geometric shape.

Both, the spectral design representation of the un-deformed geometric shape including spectral coefficients $\{\alpha_i'^x, \alpha_i'^y, \alpha_i'^z\}$ and the spectral representation of the deformed geometric shape with spectral coefficients $\{\alpha_i^x, \alpha_i^y, \alpha_i^z\}$ are generated by a spectral decomposition of a discrete operator, e.g., the discrete version of the Laplace-Beltrami operator, on the respective mesh representation. The spectral decomposition generates a basis consisting of N spectral components (eigenvectors). The functions $f^x$, $f^y$, $f^z$ representing the Euclidean coordinates of the un-deformed geometric shape and the deformed geometric shape are mapped into this basis according to equations (2), (3) and (4).

Fig. 2 now explains the procedure of step S5, generating the spatial descriptor S, in greater detail.

Steps S5.1 to S5.6 describe one possible approach to implement the procedure of step S5 for generating the spectral descriptor S. The procedure of step S5 identifies the spectral coefficients with a high relative value by comparing spectral coefficients $\{\alpha_i'^x, \alpha_i'^y, \alpha_i'^z\}$ describing the un-deformed geometric shape with spectral coefficients $\{\alpha_i^x, \alpha_i^y, \alpha_i^z\}$ describing the deformed geometric shape, separately for x-, y-, and z-coefficients.

In step S5.1, a difference measure between the spectral representation of the baseline geometric shape and the at least one deformed geometric shape is determined. For determining the difference measure, the spectral coefficients $\{\alpha_i'^x, \alpha_i'^y, \alpha_i'^z\}$ describing the baseline geometric shape may be subtracted from the corresponding spectral coefficients $\{\alpha_i^x, \alpha_i^y, \alpha_i^z\}$ describing at least one deformed geometric shape. In a subsequent step S5.2 all coefficients with a difference above a given threshold are selected as the set S of relevant coefficients $\alpha_j$.

Thus, spectral coefficients $\{\alpha_i^x, \alpha_i^y, \alpha_i^z\}$, which exceed the obtained threshold, are selected for the set S of relevant coefficients $\alpha_j$. This leads to a varying number of selected spectral coefficients depending on the initial design.

In step S4, a single deformed shape may be generated to determine the difference in the spectral domain between the baseline and the deformed shape in step S5.1. Alternatively, in step S4, a set of deformed shapes may be selected, for example, from existing data sets. The spectral descriptor of the desired deformation mode may then be generated by averaging over a set or cluster of deformed shapes that show deformation similar to the desired deformation mode. The cluster of deformed shapes with similar deformations may, for example, be visually identified or by automatically clustering shapes based on a distance in the Euclidian space.

The threshold may be determined in step S5.6 from the spectral design representation of the un-deformed geometric shape or one or more spectral representations of the deformed geometric shape. The threshold may be adapted based on an information on a quality of a reconstructed mesh representation that is reconstructed from the set S of relevant spectral coefficients $\alpha_j$.

The quality may be judged, for example, by summing up differences between the mesh representation of the determined deformation mode and the mesh representation that is reconstructed from the descriptor. The summed up differences are compared to a threshold, which can be set by the designer.

Alternatively, in step S5.2 a fixed number of coefficients may be defined as constituting the set of coefficients. In that case, the coefficients off the spectral representation of the deformed state having the greatest difference to the corresponding coefficients of the spectral design representation are selected until the given number is reached. After analyzing the quality of the descriptor this number might be adapted.

The set S of relevant spectral coefficients $\alpha_i$ of the spectral representation of the deformed state represents a sparse descriptor comprising specific information on the deformation mode in the spectral components $\psi_j$ corresponding to the spectral coefficients $\alpha_i$ of the set S of relevant spectral coefficients. Each spectral component $\psi_j$ represents a specific geometric contribution, e.g., a rotation or a translation, to the deformation defined by the determined deformation mode. By comparing the deformed geometric shape with the un-deformed geometric shape using the respective spectral representations, the procedure of Steps S5.1 and S5.2 identifies and selects those spectral components that significantly contribute to the deformation. Simultaneously, those spectral components $\psi_i$, which are constant or almost constant between the baseline geometric shape and the deformed geometric shape are ignored for generating the set S of spectral coefficients constituting the descriptor.

The set S of spectral coefficients may then be stored in a step S5.5 succeeding step S5.3 as spectral descriptor for the determined deformation mode to transform the un-deformed geometric shape into the deformed geometric shape. The generated spectral descriptor therefore only includes the relevant spectral components $\psi_j$ for deforming the baseline geometric shape to the deformed geometric shape. As the number M of spectral components $\psi_j$ included in the spectral descriptor is significantly smaller than the number of nodes N of the mesh representation of the initial design, or the number of the spectral components of the spectral design representation, the spectral descriptor provides a sparse description of the deformation of the un-deformed geometric shape into the deformed state.

An alternative embodiment of the procedure of generating the spectral descriptor may comprise further steps S5.3 and S5.4 before storing the selected set S of spectral coefficients $\alpha_i$ as the spectral descriptor. In steps S5.3 and S5.4 succeeding step S5.2, the selected set S of spectral coefficients may be examined with respect to its quality. In particular, it may be determined, if a reconstructed mesh representation generated from the selected set S of spectral coefficients in step S5.2 and the spectral representation of the deformed shape in step S4 show a sufficient correspondence.

In particular, in step S5.3 the selected set S of spectral coefficients selected in step S5.2 is used as a basis for generating the reconstructed mesh representation.

A quality of the spectral descriptor can then be judged in a subsequent step S5.4 by using the reconstructed mesh representation and as indicated above by determining a difference measure. Note that individual coefficients, $\alpha_j \in S$, belong to the spectral representation of either x-, y-, or z-coordinates. When evaluating the descriptor through reconstruction in the spatial domain, we use all three coefficients representing x-, y-, and z-direction in the spatial domain:

Assume a coefficient $\alpha_k^x \in \mathbf{S}$ was selected from the set of coefficients, $\alpha_i^x$, describing the function of x-coordinates of the mesh; for reconstruction, we use the corresponding coefficients for y- and z-coordinate as well, i.e., $\alpha_k^y$ and $\alpha_k^z$, to obtain a full reconstruction of all three dimensions in the spatial domain. We use this extended set S' with $S \subseteq S'$ that contains selected coefficients in x-, y-, and, z-direction for reconstruction:

$$\hat{f}^x = \sum_{\alpha_j^x \in S'} \alpha_j^x \psi_j \; ; \tag{8}$$

$$\hat{f}^y = \sum_{\alpha_j^y \in S'} \alpha_j^y \psi_j \; ; \qquad\qquad (9)$$

$$\hat{f}^z = \sum_{\alpha_j^z \in S'} \alpha_j^z \psi_j \; ; \qquad\qquad (10)$$

The reconstructed functions $\hat{f}^x$, $\hat{f}^y$, and $\hat{f}^z$ can then be compared in step S6.4 with the original functions $f^x$, $f^y$, and $f^z$ representing the Euclidian x-, y-, and z-coordinates in order to derive a quality measure for the generated spectral descriptor.

The quality measure can be a difference between the reconstructed mesh representation of the deformed geometric shape and the mesh representation of the deformed shape.

If, for example, the determined quality measure is below a quality threshold, the method may proceed to step S5.6 in order to adapt the threshold (original threshold) to generate an adapted threshold and repeat the procedure beginning in the step S5.2 for selecting the set S of spectral coefficients with the adapted threshold. Alternatively, the number of relevant coefficients may be adapted.

If it is determined in step S5.4 that the quality of the selected set S of spectral coefficients is sufficient, the method stores the selected set S of spectral coefficients as the spectral descriptor. The procedure of generating the spectral descriptor then terminates.

The steps S5.3 and S5.4 do not necessarily form part in all embodiments of the inventive method using the described way to select the relevant coefficients. The procedure of generating the spectral descriptor may proceed directly from step S5.2 to step S5.5. Further, the sparse descriptor may be determined by an alternative method and then used in the structural optimization as described below.

Before describing the procedure of structural optimization in step S6 using the spectral descriptor for deformation modes in more detail with reference to fig. 5, some specific examples for deformation modes are discussed as far as considered relevant for understanding the present invention.

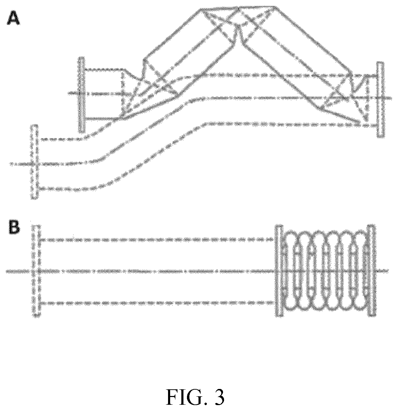

Fig. 3 depicts two specific examples for deformation modes of a physical object. The invention proposes generating and using a quantitative descriptor for complex deformation modes. The generated quantitative descriptor enables to guide a structural optimization with a specific plastic deformation of the physical object as a design criterion.

Desired plastic deformation behavior is an important objective in automotive design. Design engineers design the vehicle body structure to withstand static and dynamic loads encountered during a vehicle's lifecycle. The exterior geometric shape of the vehicle is intended to provide a low aerodynamic drag coefficient. The interior geometric shape of the vehicle provides adequate space to accommodate the occupants of the vehicle and technical components such as a motor, transmission, suspension, and so on. The vehicle body in combination with the suspension requires, for example, fulfilling a design target of minimizing road vibration and aerodynamic noise transferred to the occupants within the vehicle. In addition, the entire vehicle structure is designed to maintain its integrity in predefined crash scenarios and to provide adequate protection for its occupants. For example, vehicle crashworthiness is optimized by reducing intrusion of car components into the passenger cabin in case of a collision of the vehicle with other vehicles or other objects in the traffic environment. The design target of improving crashworthiness is addressed by performing structural optimization as a part of the design process for the vehicle body and/or its components. Traditionally, deformations of interest are measured by displacing single or multiple nodes in a finite element model of the object. Finite Element Method (FEM) or Finite Element analysis (FEA) refer to a numerical method for solving problems in engineering, which may, for example, include a structural analysis of an object. It is to be noted that Finite Element Methods and Finite Element analysis per se well known in the art and thus, repetitive explanation thereof is omitted.

Fig. 3 depicts two exemplary deformation modes. There exist two major considerations in the design of automotive structures for crash energy management:

The first consideration concerns an absorption of the kinetic energy of the vehicle. The second consideration refers to a crash resistance or a strength to sustain the crash process and/or to maintain an integrity of the passenger compartment. Concerning the energy absorption, two basic modes or mechanisms are encountered when regarding thin wall sheet metal beam type structures commonly found in vehicle bodies: axial collapse on the one hand and bending on the other hand.

The deformation mode of the physical object in the lower portion of fig. 3 is an axial deformation mode. The axial deformation mode is in many scenarios more effective in terms of energy absorption than a bending deformation mode. Exclusive axial collapse can be achieved only in energy absorbing structures, and only during direct frontal/rear and slightly off-angle impacts. Higher order, thus, more complex modes including torsion are more likely to occur in structural beam elements forming the passenger compartment of the vehicle body. A well-designed energy absorbing structure will avoid mixed deformation modes in order to assure predictable performance of the energy absorbing structure during a crash. An axial folding crash mode is considered the most effective mechanism for energy absorption. However, axial folding is also the most difficult mechanism to achieve in a real structure because of the instability problems associated with it. Object B in lower part of fig. 3 shows a typical stable axial deformation mode of collapse for a square column. In the depicted case, the deformation mode is an axial mode composed of symmetrically alternating folds.

The bending deformation mode involves formation of local hinge mechanisms and linkage-type kinematics. The bending transformation mode is a deformation mode with a lower energy absorption capability. A front-end structure of a vehicle body will predominantly tend to collapse in this type of deformation mode. Even a structure designed for axial collapse may fail in in the axial deformation mode unless very specific design rules are followed in order to enhance its stability and resistance to off-angle loading. A typical bending mode of a collapse as an example of a deformation mode of a thin wall beam type structural component is shown in fig. 3, upper portion.

Most of the members constituting the vehicle body will be subject to mixed deformation modes including both axial collapse and bending during a crash.

The quantitative descriptor for complex deformation modes according to the invention enables to describe complex deformations in a sparse and quantitative fashion. For example, axial deformation may be easily compared with bending deformation. The descriptor enables using complex plastic deformation directly as an optimization constraint or optimization objective and provides therefore the design engineer with a versatile and efficient tool for optimizing the design of an object. The spectral descriptor and the direct use of the spectral descriptor during structural optimization enables to explicitly target complex deformation modes during the physical object's design process, thereby decreasing the design process overall cost and time and resulting in an improved final structure.

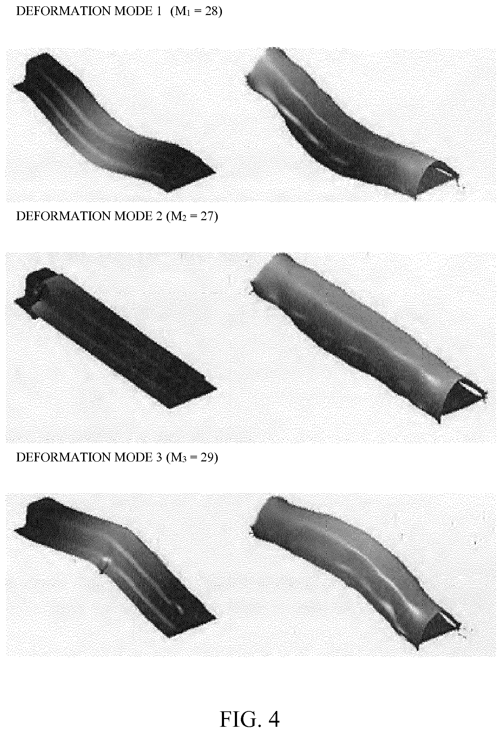

Fig. 4 provides a comparison of a deformed state according to the determined deformation mode with the reconstructed geometric shape that is reconstructed from the selected spectral components of the descriptor.

The first deformation mode shown in the upper portion of fig. 4 is an upward bend. On the left side of fig. 4, the desired deformed geometric shape (determined deformation) of the physical object is depicted. On the right side in the upper portion of fig. 4, the reconstructed deformed geometric shape from the descriptor is shown. In the case of the upward bend, the reconstructed deformed geometric shape is shown using $M_1 = 28$ coefficients of the spectral representation of the determined deformation.

The second deformation mode shown in the mid portion of fig. 4 is a crumbling deformation. On the left side of fig. 4, the desired deformed state of the physical object is depicted. On the right side in the mid portion of fig. 4, the physical object with its reconstructed deformed geometric shape from the descriptor is shown. In the case of the crumbling deformation, the reconstructed component geometric shape is shown using $M_2 = 27$ coefficients of the spectral representation for reconstructing the geometric shape of the physical object.

The third deformation mode shown in the lower portion of fig. 4 is a downward bend deformation. On the left side of fig. 4, the original deformed geometric shape of the physical object is depicted. On the right side in the lower portion of fig. 4, the physical object with its reconstructed deformed geometric shape from the characteristic spectral components is shown. In the case of the downward bend deformation, the reconstructed component geometric shape is shown using $M_3 = 29$ coefficients of the spectral representation for reconstructing the geometric shape of the physical object.

The reconstruction of the physical object, here a beam-like structure and for three specific deformation modes in fig. 4, illustrates the spectral descriptor's capability to represent the geometric information characterizing the deformation of the beam-like structure while being of a numerical size M < 30 for all depicted deformation modes. The original mesh representation of the beam-like structure may well have a number of nodes N between 8000 and 9000. The sparse geometric descriptor does not only require advantageously small memory resources, but combines this advantage with high computationally efficiency when employed for structural optimization as will be shown with reference to fig. 5.

It is noted that the inventive spectral descriptor provides not necessarily the most efficient spectral representation in terms of memory and precision of the geometric shape of the physical object, as the method does not choose a subset of spectral components with the lowest spectral coefficients for representation of the geometric shape of the physical object. Contrary thereto, the spectral descriptor generated in step S6 selects the spectral components according to their contribution to the deformation, indicated by the value or relative magnitude of the spectral coefficients $\alpha_i$.

The spectral descriptor enables to extend the analysis of the individual component's geometric contribution to the deformation. Instead of analyzing the individual component's contribution to the deformation only, identified components ae are combined in order to obtain a concise description of a deformation mode for an advantageous use in applications such as structural optimization.

The inventive spectral descriptor of deformation modes bases on the following assumptions:

Firstly, geometric shapes of physical objects can be represented as coefficients in the spectral domain.

Secondly, a subset of spectral coefficients is sufficient to store and reconstruct a mesh representation of the object and its shape.

Thirdly, crash deformations are isometric deformations and share a common spectral basis.
Two geometric objects are isometric, if a homeomorphism from one to the other exists that preserves distances (geodesic distances), for example mapping a curve to a curve with an equal arc length. This homeomorphism is called an isometry.

Fourthly, individual spectral components of that spectral representation of the geometric shape have a specific geometric interpretation, for example rotation, translation, etc.

The inventive spectral descriptor enables to identify and describe a deformation mode by a combination of a subset of spectral coefficients, which are selected according to their relevance. The subset of coefficients can be identified by finding spectral coefficients with the highest relative value or magnitude for a desired deformation mode of the object. A relative value can be found by comparing the spectral coefficients with a suitable baseline. The deformation mode is described sufficiently by the combination of the selected spectral coefficients $\alpha_j$ and their corresponding spectral components $\psi_j$ The selected spectral coefficients $\alpha_j$ form a spectral descriptor that has a much smaller size than the original mesh representation of the physical object and also the deformed state, while simultaneously preserving all relevant information that characterizes the deformation mode.

Returning to the method for structural optimization as introduced with respect to fig. 1, the advantageous use of the generated spectral descriptor provided by the procedure of step S5 for the structural optimization in the procedure according to step S7 is discussed with respect to fig. 5.

Fig. 5 shows a block diagram of steps for a structural optimization using the sparse spectral descriptor for a specific deformation mode in the procedure according to step S6 in fig. 1.

The spectral descriptor generated by the procedure in step S5 is read from the memory in step S6.1. The spectral descriptor corresponds to the specific determined deformation mode.

Step S6.2 succeeding step S6.1 determines whether the spectral descriptor is to be used as a constraint in the structural optimization. If the spectral descriptor is to be used as a constraint in the structural optimization, the steps S6.3, S6.4 and S6.5 are performed.

The objective function in an optimization problem does not necessarily capture all considerations, which might be considered when selecting an object design. Frequently, one has to account for constraints, which rule out certain regions of the design space. To incorporate a specific constraint, the underlying requirement is to be expressed in terms of the design variables. All points in the design space satisfying a chosen constraint constitute the feasible design space. The new constrained optimum design is the point in the design space with an optimum objective function, which simultaneously still lies in the feasible design space. Any of the considered responses can be constrained to user-specified limits. Typical constraints refer to mass, stress, displacements, in particular dynamic displacements, velocities, and accelerations.

A constraint is a condition that must be satisfied in order for the design to be feasible. In addition to physical laws, constraints can reflect resource limitations, user requirements, or boundaries on the validity of the analysis models. Constraints can be used explicitly by the solution algorithm, or can be incorporated into the objective function using Lagrange multipliers.

The descriptor is used in formulating constraints whenever spectral coefficients themselves are variables to be optimized. This may, for example, be the case when if the desired deformation can lie within a certain area of the design space but not outside of it. Then, coefficients describing the deformation may be used as variables to be optimized while the spectral descriptor defines constraints, which define areas of the design space that have to be excluded from the optimization.

In step S6.3, additional constraints, in addition to the spectral descriptor, are obtained. In step S6.4, the additional constraints and the spectral descriptor are used to define the constraints for the structural optimization. The defined constraints comprise constraints $g_j$ (**x**, **S**) and side constraints $x_i^l$ and $x_i^u$ and include the spectral descriptor.

In step S6.5, the objective function F(x) for the optimization is defined. A good design variable set is usually the one that gives the simplest or clearest means to evaluate the objective function F(x), or performance of the physical object design, so that the most suitable point in the design space can be selected. A point where the objective function F(x) has a maximum (minimum) represents the optimum design of the physical object. Any of the considered responses can be used as the objective function F(x) for a minimization or maximization. Often mass, strain or energy are used as the objective function F(x) in an optimization.

An objective is a numerical value that is to be maximized or minimized. For example, a design engineer may wish to maximize profit or minimize weight. Many solution methods work only with single objectives. When using these methods, the design engineer normally weights the various objectives and sums them to form a single objective. Other methods allow multi-objective optimization, such as the calculation of a Pareto front.

Using the spectral descriptor as part of the objective function allows to efficiently assess the similarity between the current state of the design to be optimized and the targeted deformation mode in each deformation step: the spectral representation of the design is generated; then coefficients that are part of the spectral descriptor are chosen, and the spectral descriptor of the current design and the spectral descriptor of the target deformation mode are compared using a suitable distance or similarity measure, for example, the cosine similarity. This measure of similarity can be used as part of the objective function to be optimized, such that the deformation behavior of the design is explicitly considered during optimization.

The spectral descriptor may either describe a desired deformation mode such that a distance of the design to the descriptor has to be minimized to obtain an optimal value of the objective function; or, the descriptor may describe a deformation that is to be avoided such that the distance of the design to the descriptor has to be maximized to obtain the optimal value of the objective function.

If, in step S6.2, it is determined that the spectral descriptor is not to be used as a constraint in the structural optimization, the steps S6.6, S6.7 and S6.8 are performed. Given this case, the structural optimization will be performed using the spectral descriptor in the objective function of the optimization problem.

In step S6.6, additional objectives, in addition to the spectral descriptor, are obtained. In step S6.7, the additional objectives and the spectral descriptor are used to define the objective function F(x, S) for the structural optimization.

In step S6.8, the constraints for the optimization are defined. The defined constraints comprise constraints $g_j$ (**x**) and side constraints $x_i^l$ and $x_i^u$.

In order to perform the structural optimization, the design variables are obtained in step S6.9 and provided to the structural optimization.

Step S6.10 then performs the structural optimization of the known optimization problem using the spectral descriptor either as constraint or in the objective function F(x, S) and generates an optimized set of design variables:

$$\begin{cases} \min_{x_i}\big(F(\mathbf{x},\mathbf{S})\big) \\ \mathrm{s.\,t.\,} g_j(\mathbf{x},\mathbf{S}) \leq 0, j = \{1,\ldots,P\} \\ x_i^l \leq x_i \leq x_i^u, i = \{1,\ldots,Q\} \end{cases} \qquad (11)$$

In (11), x = {$x_1$ ..., $x_Q$} are the design variables and F(**x**, **S**) is the objective function that is optimized, e.g., minimized with respect to the constraints $g_j$ and side constraints $x_i^l$ and $x_i^u$. The spectral descriptor is used as computationally feasible and particular efficient representation of a geometric deformation in the optimization process. To achieve this aim, the spectral descriptor is used in steps S6.3 to S6.5 for defining the constraints $g_j$(**x**, **S**) or in steps S6.6 to S6.8 for defining the objective function F(**x**, **S**).

In step S7, the optimized set of design variables resulting from the performed structural optimization in step S6.10 is output. Based on the output design variables, a specific, structurally optimized design variant for the physical object may be generated, analyzed and selected for manufacture.

The spectral descriptor allows for an efficient representation of the geometric shape of the physical object and, in particular, an efficient representation of the geometric shape and its plastic deformation in a determined deformation mode into a deformed geometric shape (target geometric shape). The spectral descriptor describes even complex deformation modes, for example, an axial bending deformation, quantitatively and simultaneously in a sparse and efficient manner. This enables the direct use of the deformation mode in the structural optimization. In particular, the spectral descriptor enables the use of the deformation mode as constraint or as objective, e.g., as the objective function in a structural optimization of the physical object.

## Claims

1. Computer-implemented method for a structural optimization of a set of design variables of a design of a physical object with respect to a deformation, wherein the physical object is a vehicle, or a component thereof,

    wherein the design variables comprise at least one of a thickness of a structural member, a choice of material and a wing span of a wing,
the method comprising steps of
obtaining (S1) an un-deformed baseline geometric shape of the physical object;
generating (S2) a spectral design representation of the baseline geometric shape;
determining a deformation mode (S3) defining a desired deformed state of the baseline geometric shape;
generating (S4) a spectral representation of the desired deformed state according to the determined deformation mode;
generating a spectral descriptor S (S5) of the deformation mode on the basis of the spectral representation and the spectral representation of the desired deformed state according to the deformation mode,
wherein the step of generating the spectral descriptor (S5) includes
determining a difference (S5.1) between the spectral representation of the baseline geometric shape and the spectral representation of the desired deformed state by subtracting spectral coefficients describing the baseline geometric shape from corresponding spectral coefficients describing the desired deformed state;
selecting (S5.2) the spectral coefficients describing the desired deformed state with a difference above a given threshold as the descriptor S of relevant coefficients;
performing a structural optimization (S6) of the set of design variables using the generated spectral descriptor S as a parameter in an objective function of the structural optimization or in at least one constraint of the structural optimization to generate an optimized set of design variables of the physical object;
outputting the optimized set of design variables (S7) of the physical object based on which a structurally optimized design variant for the physical object is generated.

2. Method according to claim 1, comprising
generating a spectral basis comprising a plurality of the spectral coefficients each associated with an eigenvector of the spectral basis by performing a spectral decomposition of a mesh representation of the design of the physical object and the desired deformed state, respectively.

3. Method according to claim 1 or 2, wherein
selecting the spectral coefficients (S5.2) is performed on the basis of each spectral coefficient's value.

4. Method according to one of the preceding claims, wherein
determining the difference (S5.1) includes determining the difference between the spectral coefficients of the spectral representation and corresponding average spectral coefficients of plural shape representations of clustered deformed designs.

5. Method according to one of the preceding claim , wherein
the threshold is determined on the basis of an average value of the spectral coefficients of the spectral representation.

6. Method according to one of the preceding claims, wherein
generating the spectral descriptor (S5) comprises determining a quality measure of the determined spectral descriptor (S5.4) by reconstructing a mesh representation of the deformed design from the selected set of spectral coefficients.

7. Method according to one of the preceding claims, wherein
the physical object is a vehicle, in particular a ground vehicle, an air vehicle or a space vehicle.

8. Method according to one of the preceding claims, wherein
the set of design variables includes parameters that change directly or indirectly at least one dimension of the physical object, grid locations of the mesh representation of the object and/or material properties of the physical object.

9. Method according to one of the preceding claims, wherein
determining the deformation mode (S3) as at least one of a bending deformation mode, an axial deformation mode or a crumbling deformation mode.

10. A computer program with program-code means for executing the steps according to one of claims 1 to 9, when the program is executed on a computer or digital signal processor.

11. A computer program-product with program-code means stored on a machine-readable medium for executing the steps according to one of claims 1 to 9, when the program is executed on a computer or digital signal processor.

**Patentansprüche**

1. Computerimplementiertes Verfahren zur Strukturoptimierung eines Satzes von Entwurfsvariablen eines Entwurfs eines physischen Objekts in Bezug auf eine Verformung, wobei das physische Objekt ein Fahrzeug oder eine Komponente davon darstellt,
wobei die Entwurfsvariablen zumindest eine der folgenden Variablen umfassen: eine Dicke eines Strukturelements, eine Materialwahl und eine Flügelspannweite eines Flügels, wobei das Verfahren folgende Schritte aufweist:

   Erhalten (S1) einer nicht verformten geometrischen Grundform des physischen Objekts;
   Erzeugen (S2) einer spektralen Entwurfsdarstellung der geometrischen Grundform;
   Bestimmen eines Verformungsmodus (S3), der einen gewünschten verformten Zustand der geometrischen Grundform definiert;
   Erzeugen (S4) einer spektralen Darstellung des gewünschten verformten Zustands gemäß dem bestimmten Verformungsmodus;
   Erzeugen eines spektralen Deskriptors S (S5) des Verformungsmodus auf der Grundlage der spektralen Darstellung und der spektralen Darstellung des gewünschten verformten Zustands gemäß dem Verformungsmodus,

   wobei der Schritt des Erzeugens des spektralen Deskriptors (S5) Folgendes umfasst:

   Bestimmen einer Differenz (S5.1) zwischen der spektralen Darstellung der geometrischen Grundform und der spektralen Darstellung des gewünschten verformten Zustands durch Subtrahieren von die geometrische Grundform beschreibenden Spektralkoeffizienten von entsprechenden den gewünschten verformten Zustand beschreibenden Spektralkoeffizienten;
   Auswählen (S5.2) der den gewünschten verformten Zustand beschreibenden Spektralkoeffizienten, deren Differenz über einem gegebenen Schwellenwert liegt, als Deskriptor S relevanter Koeffizienten;
   Durchführen einer Strukturoptimierung (S6) des Satzes von Entwurfsvariablen unter Verwendung des erzeugten spektralen Deskriptors S als Parameter in einer Zielfunktion der Strukturoptimierung oder in zumindest einer Randbedingung der Strukturoptimierung, um einen optimierten Satz von Entwurfsvariablen des physischen Objekts zu erzeugen;
   Ausgeben des optimierten Satzes von Entwurfsvariablen (S7) des physikalischen Objekts, auf dessen Grundlage eine strukturoptimierte Entwurfsvariante für das physikalische Objekt erzeugt wird.

2. Verfahren nach Anspruch 1, aufweisend den folgenden Schritt
Erzeugen einer spektralen Basis, die eine Mehrzahl an Spektralkoeffizienten umfasst, welche jeweils einem Eigenvektor der spektralen Basis zugeordnet sind, indem eine spektrale Zerlegung einer Netzdarstellung des Entwurfs des physischen Objekts bzw. des gewünschten verformten Zustands durchgeführt wird.

3. Verfahren nach Anspruch 1 oder 2, wobei
das Auswählen der Spektralkoeffizienten (S5.2) auf der Grundlage des Wertes jedes einzelnen Spektralkoeffizienten erfolgt.

4. Verfahren nach einem der vorherigen Ansprüche, wobei
das Bestimmen der Differenz (S5.1) das Bestimmen der Differenz zwischen den Spektralkoeffizienten der Spektraldarstellung und den entsprechenden durchschnittlichen Spektralkoeffizienten mehrerer Formdarstellungen von geclusterten verformten Entwürfen umfasst.

5. Verfahren nach einem der vorherigen Ansprüche, wobei
der Schwellenwert auf der Grundlage eines Mittelwerts der Spektralkoeffizienten der spektralen Darstellung bestimmt wird.

6. Verfahren nach einem der vorherigen Ansprüche, wobei
das Erzeugen des spektralen Deskriptors (S5) das Bestimmen eines Qualitätsmaßes des ermittelten spektralen Deskriptors (S5.4) durch Rekonstruieren einer Netzdarstellung des verformten Entwurfs aus dem ausgewählten Satz von Spektralkoeffizienten umfasst.

7. Verfahren nach einem der vorherigen Ansprüche, wobei
das physikalische Objekt ein Fahrzeug, insbesondere ein Land-, Luft- oder Raumfahrzeug darstellt.

**8.** Verfahren nach einem der vorherigen Ansprüche, wobei
der Satz von Entwurfsvariablen Parameter enthält, die direkt oder indirekt zumindest eine Dimension des physischen Objekts, Gitterpositionen der Netzdarstellung des Objekts und/oder Materialeigenschaften des physischen Objekts verändern.

**9.** Verfahren nach einem der vorherigen Ansprüche, wobei
im Schritt des Bestimmens des Verformungsmodus (S3) ein Biege-Verformungsmodus und/oder ein axialer Verformungsmodus und/oder ein bröckelnder Verformungsmodus gewählt werden kann.

**10.** Ein Computerprogramm mit Programmcodemitteln zum Ausführen der Schritte nach einem der Ansprüche 1 bis 9, wenn das Programm auf einem Computer oder digitalen Signalprozessor ausgeführt wird.

**11.** Ein Computerprogrammprodukt mit auf einem maschinenlesbaren Medium gespeicherten Programmcodemitteln zum Ausführen der Schritte nach einem der Ansprüche 1 bis 9, wenn das Programm auf einem Computer oder digitalen Signalprozessor ausgeführt wird.


**Revendications**

**1.** Procédé mis en oeuvre par ordinateur pour une optimisation structurelle d'un jeu de variables de conception d'une conception d'un objet physique par rapport à une déformation, dans lequel l'objet physique est un véhicule, ou un composant de celui-ci,

dans lequel les variables de conception comprennent au moins l'un parmi une épaisseur d'un élément structurel, un choix de matériau et une envergure d'une aile,
le procédé comprenant les étapes consistant en
l'obtention (S1) d'une forme géométrique de référence non déformée de l'objet physique ;
la génération (S2) d'une représentation de conception spectrale de la forme géométrique de référence ;
la détermination d'un mode de déformation (S3) définissant un état déformé souhaité de la forme géométrique de référence ;
la génération (S4) d'une représentation spectrale de l'état déformé souhaité en fonction du mode de déformation déterminé ;
la génération d'un descripteur spectral S (S5) du mode de déformation sur la base de la représentation spectrale et de la représentation spectrale de l'état déformé souhaité en fonction du mode de déformation,
dans lequel l'étape de la génération du descripteur spectral (S5) comporte
la détermination d'une différence (S5.1) entre la représentation spectrale de la forme géométrique de référence et la représentation spectrale de l'état déformé souhaité par la soustraction de coefficients spectraux décrivant la forme géométrique de référence à des coefficients spectraux correspondants décrivant l'état déformé souhaité ;
la sélection (S5.2) des coefficients spectraux décrivant l'état déformé souhaité avec une différence au-dessus d'un seuil donné en tant que le descripteur S de coefficients pertinents ;
la réalisation d'une optimisation structurelle (S6) du jeu de variables de conception en utilisant le descripteur spectral S généré en tant que paramètre dans une fonction objective de l'optimisation structurelle ou dans au moins une contrainte de l'optimisation structurelle pour générer un jeu optimisé de variables de conception de l'objet physique ;
la délivrance du jeu optimisé de variables de conception (S7) de l'objet physique sur la base duquel une variante de conception structurellement optimisée pour l'objet physique est générée.

**2.** Procédé selon la revendication 1, comprenant
la génération d'une base spectrale comprenant une pluralité des coefficients spectraux chacun associés à un vecteur propre de la base spectrale par la réalisation d'une décomposition spectrale d'une représentation maillée respectivement de la conception de l'objet physique et de l'état déformé souhaité.

**3.** Procédé selon la revendication 1 ou 2, dans lequel
la sélection des coefficients spectraux (S5.2) est réalisée sur la base de la valeur de chaque coefficient spectral.

**4.** Procédé selon l'une des revendications précédentes, dans lequel
la détermination de la différence (S5.1) comporte la détermination de la différence entre les coefficients spectraux de la représentation spectrale et des coefficients spectraux moyens correspondants de plusieurs représentations de forme de conceptions déformées regroupées.

5.  Procédé selon l'une des revendications précédentes, dans lequel
    le seuil est déterminé sur la base d'une valeur moyenne des coefficients spectraux de la représentation spectrale.

6.  Procédé selon l'une des revendications précédentes, dans lequel
    la génération du descripteur spectral (S5) comprend la détermination d'une mesure de qualité du descripteur spectral déterminé (S5.4) par la reconstruction d'une représentation maillée de la conception déformée à partir du jeu sélectionné de coefficients spectraux.

7.  Procédé selon l'une des revendications précédentes, dans lequel
    l'objet physique est un véhicule, en particulier un véhicule terrestre, un véhicule aérien ou un véhicule spatial.

8.  Procédé selon l'une des revendications précédentes, dans lequel
    le jeu de variables de conception comporte des paramètres qui changent directement ou indirectement au moins une dimension de l'objet physique, des emplacements de grille de la représentation maillée de l'objet et/ou des propriétés de matériau de l'objet physique.

9.  Procédé selon l'une des revendications précédentes, dans lequel
    la détermination du mode de déformation (S3) en tant qu'au moins l'un parmi un mode de déformation par flexion, un mode de déformation axiale ou un mode de déformation par effondrement.

10. Programme informatique avec des moyens de code de programme pour exécuter les étapes selon l'une des revendications 1 à 9, lorsque le programme est exécuté sur un ordinateur ou un processeur de signal numérique.

11. Produit de programme informatique avec des moyens de code de programme stockés sur un support lisible par machine pour exécuter les étapes selon l'une des revendications 1 à 9, lorsque le programme est exécuté sur un ordinateur ou un processeur de signal numérique.

OBTAIN MESH
REPRESENTATION OF
BASELINE SHAPE
— S1

S4

GENERATE SPECTRAL
REPRESENTATION OF
BASELINE SHAPE
— S2

DETERMINE
DEFORMATION MODE

SPECTRAL
REPRESENTATION(S) OF
DEFORMED SHAPE(S)

S3

GENERATE SPECTRAL
DESCRIPTOR **S**
— S5

STRUCTURAL
OPTIMIZATION
— S6

OUTPUT OPTIMIZED
SET OF DESIGN
VARIABLES
— S7

FIG. 1

FIG. 2

FIG. 3

DEFORMATION MODE 1 ($M_1 = 28$)

DEFORMATION MODE 2 ($M_2 = 27$)

DEFORMATION MODE 3 ($M_3 = 29$)

FIG. 4

FIG. 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **LEIVA, J. P.** Structural Optimization Methods and Techniques to design Efficient Car Bodies. *12th European Conference on Research and Advanced Technology for Digital Libraries, ECDL 2008, 5173 LNCS,* 2008
- **Z. KARNI ; C. GOTSMAN.** Spectral Compression of Mesh Geometry. *Proceedings of the 27th Annual Conference on Computer Graphics and Interactive Techniques - SIGGRAPH '00,* 2000, 279-286
- **O. SORKINE.** Laplacian Mesh Processing. *EUROGRAPHICS '05,* 2005, vol. 109, 318
- **J. GARCKE ; R. IZA-TERAN.** Machine Learning Approaches for Data from Car Crashes and Numerical Car Crash Simulation. *International Association for the Engineering Analysis Community- NAFEMS,* 2017
- **R. IZA-TERAN, BONN.** *Geometrical Methods for the Analysis of Simulation Bundles,* September 2016
- **R. IZA-TERAN ; J. GARCKE.** Geometrical Method for Low-Dimensional Representation of Simulations. *arXiv preprint: 1903.077744,* 2019